# EUROPÄISCHE PATENTSCHRIFT

(11) **EP 3 523 696 B1**
(45) Veröffentlichungstag und Bekanntmachung des Hinweises auf die Patenterteilung: **13.01.2021**
(21) Anmeldenummer: 17787363.5
(22) Anmeldetag: 09.10.2017
(51) Int. Cl.: G03F 7/09, B41C 1/00, B41M 1/00, G03F 7/20

(54) **VERBUNDPLATTE MIT SPERRSCHICHT UND VERFAHREN ZUR HERSTELLUNG EINER HOCHDRUCKPLATTE**
COMPOSITE PLATE WITH BARRIER LAYER AND METHOD FOR PRODUCING A HIGH PRESSURE PLATE
PLAQUE COMPOSITE DOTÉE D'UNE COUCHE BARRIÈRE ET PROCÉDÉ DE FABRICATION D'UNE PLAQUE HAUTE PRESSION

(30) Priorität: 10.10.2016 EP 16193101; 07.09.2017 EP 17189967
(43) Veröffentlichungstag der Anmeldung: 14.08.2019
(73) Patentinhaber: AKK GmbH, 47809 Krefeld (DE)
(72) Erfinder: KESPER, Peter, 47800 Krefeld (DE)
(74) Vertreter: Cohausz & Florack
(86) Internationale Anmeldenummer: PCT/EP2017/075663
(87) Internationale Veröffentlichungsnummer: WO 2018/069242

(56) Entgegenhaltungen:
- EP-A1- 0 848 296
- EP-A1- 2 950 146
- GB-A- 2 023 861
- JP-A- S6 043 660
- JP-A- 2009 063 873
- US-A1- 2004 081 908

## Beschreibung

Die Erfindung betrifft eine Verbundplatte zur Verwendung in der Herstellung einer Hochdruckplatte, insbesondere einer Flexodruckplatte, mit einer Trägerschicht, mit mindestens einer Fotoschicht, welche über elektromagnetische Strahlung in einem Wellenlängenbereich strukturierbar ist, wobei die Fotoschicht auf der Trägerschicht angeordnet ist. Weiter betrifft die Erfindung ein Verfahren zur Herstellung einer Hochdruckplatte unter Verwendung mindestens einer Verbundplatte sowie ein Verfahren zur Herstellung einer erfindungsgemäßen Verbundplatte. Schließlich betrifft die Erfindung die Verwendung eines Verbundmaterials in einer Verbundplatte für eine Hochdruckplatte.

Hochdruckplatten, beispielsweise Flexodruckplatten, sind Reliefplatten, bei welchen die bildgebenden Abschnitte gegenüber einer Grundfläche erhöht ausgestaltet sind. Zur Herstellung von Hochdruckplatten werden insbesondere Verbundplatten, beispielsweise schichtförmige Verbundplatten verwendet, welche für den Hochdruck strukturiert werden.

Solche Verbundplatten weisen insbesondere eine Trägerschicht und mindestens eine Fotoschicht auf. Die Trägerschicht dient hierbei beispielsweise der mechanischen Stabilisierung der Verbundplatte. Die Fotoschicht weist ein Material auf, welches seine Eigenschaften unter Einwirkung von elektromagnetischer Strahlung verändert. Wird die Fotoschicht selektiv belichtet, verändern sich beispielsweise die Löslichkeit, das Aushärteverhalten und/oder die Hafteigenschaften der von der selektiven Belichtung betroffenen Abschnitte der Fotoschicht. Beispielsweise durch eine chemische Behandlung können dann selektiv die Abschnitte höherer Löslichkeit, niedrigerer Härte und/oder niedrigerer Haftung entfernt werden, um eine Reliefstruktur zu erhalten. Die selektive Belichtung wird üblicherweise unter Verwendung eines Maskenmaterials bewirkt, wobei das Maskenmaterial die Abschnitte der Fotoschicht, welche nicht belichtet werden sollen, gegenüber der eingehenden Strahlung abdeckt.

Aus der Praxis ist bekannt, als Maskenmaterial einen fotografischen Film auf die Fotoschicht aufzubringen. Der fotografische Film kann mit hierzu bekannten Methoden selektiv belichtet und entwickelt werden, so dass eine teilweise transparente, teilweise opake Maskenschicht auf der Fotoschicht entsteht. Entsprechende Verfahren werden dabei beispielsweise als *analoge Verfahren* bezeichnet. Die hieraus resultierende Qualität der Oberflächenstruktur und die Auflösung der Hochdruckplatte sind jedoch verbesserungswürdig. Die Verfügbarkeit von fotografischen Filmen ist zudem über die letzten Jahre zurückgegangen, so dass der Einsatz von fotografischen Filmen zur Herstellung von Hochdruckplatten nicht mehr weit verbreitet ist.

Eine Alternative zur Verwendung von fotografischen Filmen als Maskenmaterial ist die Aufbringung einer opaken Maskenschicht (*black mask*), welche insbesondere durch optische Verfahren wie Laserablation selektiv entfernt wird. Üblicherweise wird die Laserablation über computergestützte Verfahren vorgenommen und beispielsweise als *digitales Verfahren* oder *direct-to-plate-*Verfahren bezeichnet. Mit der selektiven Entfernung des Maskenmaterials verbleibt eine strukturierte Maske, welche die Fotoschicht nur teilweise abdeckt. Die auf Ablation eines Maskenmaterials beruhenden Verfahren sind jedoch apparativ aufwändig und erlauben normalerweise keine hohen Prozessgeschwindigkeiten.

Weiter ist es üblich, dass die Verbundplatten zur Verwendung in der Herstellung von Hochdruckplatten mit einer Schutzschicht ausgestattet werden. Als Schutzschicht dienen hierbei beispielsweise Kunststofffolien, welche die Fotoschicht abdecken, um die Fotoschicht vor mechanischen Einwirkungen wie Kratzern und vor Verunreinigungen wie Staub zu schützen. Die Schutzschichten erlauben hierbei jedoch keine prozesssichere und qualitativ hochwertige selektive Belichtung der Fotoschicht und sind dafür vorgesehen, vor einer selektiven Belichtung und insbesondere vor einer Aufbringung des Maskenmaterials entfernt zu werden.

Der Stand der Technik aus den US 2004/081908 A1, EP 08 48 296 A1 und JP 2009 063873 A offenbart Flexodruckplattenvorläufer, welche eine Trägerschicht, Fotoschicht, Sperrschicht und Maskenschicht aufweisen. Diese repräsentieren den nächstliegenden Stand der Technik.

Der vorliegende Erfindung liegt die Aufgabe zugrunde, eine Verbundplatte zur Verwendung in der Herstellung einer Hochdruckplatte und ein Verfahren zur Herstellung einer Hochdruckplatte vorzuschlagen, welche die zuvor genannten Nachteile aus dem Stand der Technik reduzieren und insbesondere eine effektive Herstellung der Hochdruckplatte mit guter Auflösung ermöglichen. Weiter werden ein Verfahren zur Herstellung einer erfindungsgemäßen Verbundplatte sowie eine Verwendung eines Verbundmaterials in einer Verbundplatte für eine Hochdruckplatte zur Lösung dieser Aufgabe genannt.

Gemäß der ersten Lehre der Erfindung wird die genannte Aufgabe betreffend eine Verbundplatte dadurch gelöst, dass eine Sperrschicht vorgesehen ist, wobei die Sperrschicht auf der von der Trägerschicht abgewandten Seite der Fotoschicht angeordnet ist, die Sperrschicht im Wesentlichen transparent in dem Wellenlängenbereich ist, in welchem die Fotoschicht strukturierbar ist und auf der Sperrschicht mindestens ein Maskenmaterial angeordnet ist, wobei das Maskenmaterial Diazoverbindungen umfasst und das Maskenmaterial durch Laminieren aufgebracht ist.

Die Verbundplatte ist hierbei insbesondere eine schichtförmige Verbundplatte umfassend eine Anzahl von Schichten, welche über deren Erstreckungsflächen miteinander in Verbindung stehen. Die einzelnen Schichten, insbesondere die Trägerschicht, die Fotoschicht und die Sperrschicht sind hierbei insbesondere durchgängige Schichten, d.h. die Schichten sind flächig ausgebildet und weisen insbesondere keine Ausnehmungen auf. Insbesondere sind einzelne oder alle Schichten fest miteinander verbunden, beispielsweise durch Adhäsion und/oder durch einen Materialschluss.

Die Trägerschicht dient insbesondere einer mechanischen Stabilisierung der Verbundplatte und der daraus hergestellten Hochdruckplatte. Die Trägerschicht kann für einen Schutz vor mechanischen Beanspruchungen eingerichtet sein und der Verbundplatte für das vorgesehene Druckverfahren und die vorgesehene Druckvorrichtung entsprechende mechanische Eigenschaften bereitstellen. Die Trägerschicht umfasst beispielsweise mindestens eines der folgenden Materialien oder besteht hieraus: zellulosehaltige Materialien, Papier, Pappe, Kunststoffe und/oder Metall. Insbesondere sind Materialien auf der Basis von Polymeren vorgesehen, beispielsweise auf der Basis von Polyester, Polystyren, Polyolefin und/oder Polyamid. Insbesondere basiert oder besteht die Trägerschicht aus Polyethylenterephtalat. Die Trägerschicht kann auch auf Polyvinyl basiert sein oder hieraus bestehen, insbesondere mindestens einem wasserlöslichen Polyvinyl.

Die mindestens eine Fotoschicht ist über elektromagnetische Strahlung in einem Wellenlängenbereich beispielsweise nach dem Prinzip eines Fotoresist strukturierbar. Beispielsweise wird die Löslichkeit, Härte, Haftungseigenschaft und/oder die Aushärtbarkeit des Materials der Fotoschicht von Strahlung in einem solchen Wellenlängenbereich beeinflusst, so dass nach einem Belichten und insbesondere einem nachfolgenden Aushärten bzw. Entwickeln eine selektive Entfernung der Fotoschicht ermöglicht wird. Beispielsweise nimmt die Löslichkeit aufgrund einer Belichtung in diesem Wellenlängenbereich ab, womit die nicht belichteten Abschnitte der Fotoschicht gelöst bzw. entfernt werden können. Ebenso kann die Löslichkeit aufgrund einer Belichtung in diesem Wellenlängenbereich zunehmen, so dass mit einer Lösung vorwiegend die belichteten Bereiche entfernt werden können. Die Fotoschicht kann somit positive oder negative Belichtungseigenschaften aufweisen.

Der Wellenlängenbereich der elektromagnetischen Strahlung zur Strukturierung der Fotoschicht kann sich beispielsweise innerhalb des sichtbaren Bereichs erstrecken und/oder außerhalb des sichtbaren Bereichs liegen. Insbesondere liegt der Wellenlängenbereich im Ultravioletten, d.h. beispielsweise innerhalb eines Bereichs von 100 nm bis 380 nm, und/oder im violetten sichtbaren Bereich, d.h. beispielsweise innerhalb eines Bereichs von 380 nm bis 425 nm.

Die Fotoschicht kann hierbei insbesondere auf Fotopolymeren basieren und/oder insbesondere in fester Form vorliegen. Entsprechende Fotopolymere und Methoden zur selektiven Strukturierung von Fotoschichten sind dem Fachmann aus dem Fachwissen vertraut und werden beispielsweise in Ullmanns Encyklopädie der technischen Chemie, 4. Auflage, Verlag Chemie (1981) beschrieben.

Die Fotoschicht ist auf der Trägerschicht angeordnet. Die Fotoschicht kann hierbei direkt auf der Trägerschicht angeordnet sein, d.h. im Kontakt zu der Trägerschicht stehen. Alternativ können eine oder mehrere Zwischenschichten zwischen Trägerschicht und Fotoschicht angeordnet sein, insbesondere mindestens eine Haftvermittlerschicht, welche dafür eingerichtet ist, die Bindung zwischen Trägerschicht und Fotoschicht bereitzustellen.

Eine Sperrschicht ist vorgesehen, wobei die Sperrschicht auf der von der Trägerschicht abgewandten Seite der Fotoschicht angeordnet ist. Insbesondere ist die Sperrschicht direkt auf der Fotoschicht angeordnet, d.h. die Sperrschicht steht im Kontakt zu der Fotoschicht. Hierbei ist die Sperrschicht im Wesentlichen transparent in dem Wellenlängenbereich, in welchem die Fotoschicht strukturierbar ist.

Mit im Wesentlichen transparent ist gemeint, dass ein Großteil der Strahlungsintensität in dem betreffenden Wellenlängenbereich durch die Sperrschicht dringen kann, insbesondere können mindestens 50 %, bevorzugt mindestens 75 %, weiter bevorzugt mindestens 95 % der einfallenden Intensität die Sperrschicht durchdringen. Als Schichtdicke wird die mittlere Dicke der Schicht senkrecht zu der größten Fläche der Schicht verstanden.

Die Sperrschicht dient hierbei insbesondere als Diffusionssperrschicht, wobei die Sperrschicht einen Kontakt der Fotoschicht mit der umliegenden Atmosphäre unterbinden soll. Die Sperrschicht ist daher vorzugsweise durchgehend bzw. flächig auf der Fotoschicht vorgesehen und deckt die Fotoschicht bereichsweise oder vollständig auf einer Fläche ab.

Es hat sich herausgestellt, dass die Qualität und Auflösung der aus der Verbundplatte hergestellten Druckplatte über die Sperrschicht verbessert werden kann. Die Sperrschicht verbleibt bei einer bei einer Belichtung der Fotoschicht und ggf. einer Belichtung eines Maskenmaterials auf der Fotoschicht. Während Schutzschichten auf der Fotoschicht aus dem Stand der Technik vor der Belichtung üblicherweise entfernt werden müssen, wird ein Verbleib der Sperrschicht der vorliegenden Erfindung insbesondere durch die vorzugsweise geringe Schichtdicke von weniger als 20 µm ermöglicht, wobei durch die Brechung der zur Belichtung der Fotoschicht eingesetzten Strahlung an der Sperrschicht nur geringe Qualitätsverluste hervorgerufen werden. Bei der durch die Belichtung ausgelösten fotochemischen Reaktion der Fotoschicht wird der Einfluss der umgebenden Atmosphäre durch die Sperrschicht signifikant reduziert, was zu einer deutlichen Qualitätssteigerung der strukturierten Oberfläche der Fotoschicht führt. Ohne an eine bestimmte Theorie gebunden zu sein, wird angenommen, dass im Stand der Technik vorrangig eine Reaktion der Fotoschicht mit Sauerstoff für einen Qualitätsverlust der strukturierten Oberfläche der Fotoschicht verantwortlich ist, was durch die erfindungsgemäße Sperrschicht vermindert werden kann. Gleichzeitig wurde festgestellt, dass durch die geringe Schichtdicke der Sperrschicht insbesondere Brechungseffekte der Sperrschicht, welche die Auflösung negativ beeinflussen, soweit reduziert werden, dass im Ergebnis die Qualität der hergestellten Hochdruckplatten verbessert wird. Insbesondere weist die Sperrschicht Materialien auf der Basis von Polymeren auf oder besteht aus diesen. Solche Polymere umfassen beispielsweise Poylester, Polystyren, Polyolefin und/oder Polyamid. Insbesondere basiert oder besteht die Sperrschicht aus Polyethylenterephtalat. Die Sperrschicht kann auch auf Polyvinyl basiert sein oder hieraus bestehen, insbesondere mindestens einem wasserlöslichen Polyvinyl. Andere Materialien, welche eine ausreichende Diffusionssperrwirkung der Sperrschicht bereitstellen und im betreffenden Wellenlängenbereich im Wesentlichen transparent sind, sind ebenfalls denkbar. Insbesondere ist das Material der Sperrschicht verschieden von dem Material der Fotoschicht und/oder der Trägerschicht.

Die Gesamtdicke der Verbundplatte beträgt beispielsweise von 0,5 mm bis 3,0 mm, insbesondere von 1,0 mm bis 2,8 mm. Die Trägerschicht kann beispielsweise eine Schichtdicke von 0,05 mm bis 0,2 mm aufweisen, insbesondere von 0,1 mm bis 0,15 mm. In einer Ausgestaltung weist die Verbundplatte zusätzlich zu Trägerschicht, Fotoschicht und Sperrschicht mindestens eine Zwischenschicht auf, beispielsweise mindestens eine Haftvermittlerschicht, welche zwischen Trägerschicht und Fotoschicht angeordnet ist. Optional kann eine Schutzschicht auf dem Maskenmaterial vorgesehen sein, wobei die Schutzschicht insbesondere dafür eingerichtet ist, vor einer Belichtung und/oder einer Strukturierung des Maskenmaterials entfernt zu werden.

In einer Ausgestaltung der Verbundplatte weist die Sperrschicht eine Schichtdicke von höchstens 100 µm, vorzugsweise höchsten 20 µm und weiter vorzugsweise höchstens 10 µm auf. Hohe Schichtdicken auch oberhalb von 100 µm sind insbesondere für die mechanische Stabilität der Sperrschicht vorteilhaft. Grundsätzlich ist die Wahl der Schichtdicke in einem weiten Bereich möglich. Wesentliche zu beachtenden Effekte sind der Einfluss der Dicke auf die mechanische Stabilität und die optischen Eigenschaften. Mit geringen Schichtdicken von vorzugsweise höchstens 10 µm kann ein Brechungseffekt der eingehenden Strahlung, welche zur Beleuchtung der Fotoschicht verwendet wird, weiter reduziert werden. Hiermit wird die Qualität und Auflösung der resultierenden Oberflächenstruktur der Fotoschicht weiter gesteigert.

Die Qualität und Auflösung kann in einer weiteren Ausgestaltung zusätzlich erhöht werden, wenn die Sperrschicht eine Schichtdicke von höchstens 5 µm aufweist.

Auf der Sperrschicht ist mindestens ein Maskenmaterial angeordnet. Ein Maskenmaterial wird insbesondere für eine selektive Belichtung der Fotoschicht verwendet. Das Maskenmaterial ist hierbei insbesondere opak in dem Wellenlängenbereich, in welchem die Fotoschicht strukturiert werden kann. Somit werden bei einer Belichtung die Abschnitte der Fotoschicht belichtet, welche nicht von einem Maskenmaterial abgedeckt werden, während die von dem Maskenmaterial abgedeckten Abschnitte im Wesentlichen keine Belichtung erfahren. Das Maskenmaterial ist insbesondere direkt auf der Sperrschicht angeordnet, d.h. das Maskenmaterial steht in Kontakt zu der Sperrschicht.

Das Maskenmaterial kann als Schicht ausgebildet sein, insbesondere als durchgängige, flächige Schicht, welche insbesondere die Fotoschicht und/oder Sperrschicht vollständig abdeckt. Das Maskenmaterial ist dann beispielsweise für eine spätere Strukturierung vorgesehen. Das Maskenmaterial umfasst ein mittels elektromagnetischer Strahlung im sichtbaren Bereich strukturierbares Material oder besteht daraus, beispielsweise nach dem Prinzip eines Fotoresist.

Das Maskenmaterial kann ebenso eine Struktur zur selektiven Belichtung der Fotoschicht aufweisen. Die Struktur des Maskenmaterials wird durch eine selektive Belichtung bzw. Entwicklung und selektive Entfernung strukturiert. Bei der Strukturierung des Maskenmaterials, welche über eine Lösung bewirkt wird, ist zudem die Anordnung der erfindungsgemäßen Sperrschicht vorteilhaft, da eine Einwirkung der Lösung auf die Fotoschicht unterbunden wird. Nicht erfindungsgemäß kann das Maskenmaterial strukturiert aufgebracht worden sein, beispielweise mittels eines Druckverfahrens.

Das Maskenmaterial umfasst Diazoverbindungen oder besteht hieraus. Die Diazoverbindungen ändern hierbei unter Einwirkung von elektromagnetischer Strahlung im sichtbaren Bereich die Eigenschaften des Maskenmaterials, so dass das Maskenmaterial über eine Belichtung strukturiert und selektiv abgelöst werden kann. Entsprechende Diazoverbindungen, insbesondere mit weiteren Kupplungskomponenten, sind dem Fachmann aus dem Stand der Technik bekannt und beispielsweise in Römpp, Chemie Lexikon, 7. Auflage, Franckh'sche Verlagshandlung (1973) insbesondere unter Lichtpausen und Diazoverbindungen beschrieben. Insbesondere wird ein Maskenmaterial aufweisend Diazoverbindungen verwendet, welches nach einer selektiven Belichtung selektiv mit Ammoniak und/oder mit Wasser abgelöst werden kann. Das Maskenmaterial wird im sichtbaren Bereich, beispielsweise einer Wellenlänge von ca. 405 nm selektiv belichtet, um die Löslichkeit des Maskenmaterials zu beeinflussen. Ein spezielles Beispiel einer Diazoverbindung ist Diazonaphthoquinon (DNQ).

In einer nicht erfindungsgemäßen Ausgestaltung umfasst das Maskenmaterial Tinte und/oder Wachs. Nicht erfindungsgemäß wird das Maskenmaterial aufgedruckt, wobei Wachs und/oder Tinte besonders prozesssicher eingesetzt werden können. Die Tinte kann insbesondere eine UV-härtbare Tinte und/oder pastöse Tinte sein. Besonders eine Kombination von Wachs und UV-härtbarer Tinte ist vorteilhaft als Maskenmaterial bei der Durchführung eines Aufdruckens.

In einer weiteren Ausgestaltung der Verbundplatte ist die Verbundplatte zur Verwendung in der Herstellung einer Flexodruckplatte eingerichtet. Flexodruckplatten werden beispielsweise für das Bedrucken von Pappe, Papier, Filmen, Folien und/oder Laminaten eingesetzt und eignen sich insbesondere für die großtechnische Produktion und das Bedrucken großflächiger Werkstücke. Flexible Eigenschaften der Flexodruckplatten können beispielsweise über eine entsprechende Ausgestaltung der Trägerschicht und der Fotoschicht, beispielsweise über die Materialauswahl und/oder die Schichtdicke eingestellt werden.

Gemäß einer zweiten Lehre der vorliegenden Erfindung wird die oben genannte Aufgabe durch ein Verfahren zur Herstellung einer Hochdruckplatte unter Verwendung mindestens einer Verbundplatte gelöst, mit einer Trägerschicht, mit mindestens einer Fotoschicht, welche über elektromagnetische Strahlung in einem Wellenlängenbereich strukturierbar ist, wobei die Fotoschicht auf der Trägerschicht angeordnet ist, mit einer Sperrschicht, wobei die Sperrschicht auf der von der Trägerschicht abgewandten Seite der Fotoschicht angeordnet ist, wobei die Sperrschicht im Wesentlichen transparent in dem Wellenlängenbereich ist, in welchem die Fotoschicht strukturierbar ist, bei dem mindestens ein Maskenmaterial auf die Verbundplatte durch Laminieren aufgebracht und das Maskenmaterial selektiv strukturiert wird, wobei mindestens ein Maskenmaterial umfassend Diazoverbindungen verwendet wird, bei dem die Fotoschicht zumindest in dem Wellenlängenbereich, in welchem die Fotoschicht strukturierbar ist, selektiv belichtet wird und bei dem die selektiv belichtete Fotoschicht selektiv entfernt wird.

Wie bereits zur oben beschriebenen Verbundplatte ausgeführt, ermöglicht die Sperrschicht eine Verbesserung der Qualität und Auflösung der aus der Verbundplatte hergestellten Hochdruckplatte. Die Sperrschicht verbleibt bei der Belichtung der Fotoschicht auf der Fotoschicht, wobei die Belichtung insbesondere durch die geringe Schichtdicke von höchstens 20 µm, insbesondere höchstens 10 µm möglich wird, da Brechungseffekte an der Sperrschicht ggf. nur geringe Qualitätsverluste hervorrufen. Bei der durch die Belichtung ausgelösten fotochemischen Reaktion der Fotoschicht wird der Einfluss der umgebenden Atmosphäre durch die Sperrschicht gleichzeitig signifikant reduziert.

Das Aufbringen von Maskenmaterial kann anhand verschiedener Methoden bzw. Kombinationen von Methoden vorgenommen werden. Beispielsweise wird das Maskenmaterial laminiert, kalandriert, aufgesprüht, aufgedruckt, aufgelegt und/oder manuell auf der Verbundplatte angeordnet. Mindestens ein Maskenmaterial wird laminiert. Insbesondere wird mindestens ein Maskenmaterial mittels mindestens einer Trägerfolie bzw. Releasefolie aufgebracht, wobei die Trägerfolie nach dem Aufbringen insbesondere wieder entfernt wird. Es können auch mehrere verschiedene Maskenmaterialien in einem oder mehreren, aufeinander folgenden und/oder gleichzeitig vorgenommen Verfahrensschritten aufgebracht werden. Das Maskenmaterial kann mit der Aufbringung, beispielsweise durch eine selektive Aufbringung und/oder im Anschluss an die Aufbringung mit weiteren Methoden strukturiert werden.

Die selektive Strukturierung der Fotoschicht wird insbesondere mittels aus dem Fachwissen bekannten Methoden, beispielsweise einem Entwickeln und selektiven Entfernen durch chemische und/oder mechanische Methoden nach einem selektiven Belichten durchgeführt. Beispielsweise reagiert die Fotoschicht positiv auf eine Belichtung, so dass die belichteten Abschnitte selektiv abgelöst werden können. Beispielsweise reagiert die Fotoschicht negativ auf eine Belichtung, so dass die unbelichteten Abschnitte selektiv abgelöst werden können.

In einer Ausgestaltung des Verfahrens wird mindestens ein Maskenmaterial als Schicht aufgebracht. Insbesondere handelt es sich hierbei um eine durchgängige, flächige Schicht, welche anschließend strukturiert werden kann, um eine selektive Belichtung der Fotoschicht zu ermöglichen.

Das Maskenmaterial ist dafür eingerichtet, dessen Eigenschaften über die Einwirkung von elektromagnetischer Strahlung im sichtbaren Bereich zu verändern. Eine Strukturierung des Maskenmaterials kann in einer Ausgestaltung des Verfahrens dadurch bewirkt werden, dass das Maskenmaterial selektiv belichtet und anschließend selektiv entfernt wird. Eine Entfernung des Maskenmaterials kann beispielsweise über eine chemische Behandlung und/oder eine mechanische Behandlung durchgeführt werden. Das Maskenmaterial, dessen Löslichkeit selektiv über die Belichtung eingestellt wurde, wird mit einem Lösungsmittel selektiv entfernt, insbesondere unter Einwirkung mechanischer Mittel.

Mindestens ein Maskenmaterial umfassend Diazoverbindungen wird verwendet. Wie bereits zur oben beschriebenen Verbundplatte ausgeführt, ergeben Maskenmaterialien basierend auf Diazoverbindungen eine prozesssichere Möglichkeit zur Bereitstellung einer Maske zur Belichtung der Fotoschicht. Insbesondere wird ein Maskenmaterial aufweisend Diazoverbindungen verwendet, welches nach einer selektiven Belichtung selektiv mit Ammoniak und/oder Wasser abgelöst wird. Das Maskenmaterial kann im sichtbaren Bereich, beispielsweise bei einer Wellenlänge von 405 nm selektiv belichtet werden, um die Löslichkeit des Maskenmaterials zu beeinflussen.

In einer nicht erfindungsgemäßen Ausgestaltung des Verfahrens wird mindestens ein Maskenmaterial aufgedruckt. Ein Aufdrucken des Maskenmaterials erlaubt eine apparativ einfache und qualitativ hochwertige Aufbringung des Maskenmaterials. Ebenso kann das mindestens eine Maskenmaterial über das Aufdrucken bereits strukturiert werden, so dass weitere Schritte zur Strukturierung des Maskenmaterials zumindest teilweise oder ganz entfallen können.

In einer Ausgestaltung des Verfahrens umfasst das Maskenmaterial Tinte und/oder Wachs oder besteht daraus. Wie bereits zu der oben nicht erfindungsgemäßen beschriebenen Druckplatte ausgeführt, ist Tinte und/oder Wachs als Maskenmaterial insbesondere für ein Aufdrucken des Maskenmaterials vorteilhaft.

In einer nächsten Ausgestaltung des Verfahrens wird mindestens eine Platte aus dem oben beschriebenen Verbundwerkstoff abschnittsweise auf einem Hochdruckträger befestigt. Insbesondere bei großen Hochdruckformen, beispielsweise Flexodruckformen, wie diese beim Bedrucken von Wellpappe eingesetzt werden, wobei darüber hinaus große Bereiche unbedruckt bleiben, sind vollflächige Hochdruckplatten zu kostenintensiv. Durch diese Ausgestaltung des Verfahrens wird eine reproduzierbare und außerordentlich präzise Ausrichtung der Hochdruckplatte gegenüber einem Hochdruckträger gewährleistet, so dass beispielsweise großflächige Objekte mit hoher Genauigkeit bedruckt werden können.

Dies wird einerseits dadurch bewirkt, dass die Belichtung der Hochdruckplatte erst nach dem Befestigen der Hochdruckplatte auf den Hochdruckträger erfolgt, wobei das Maskenmaterial zur Belichtung mit einfachen Mitteln sehr präzise gegenüber dem Hochdruckträger ausgerichtet werden kann. Beispielsweise wird ein Register zur Ausrichtung verwendet. Eine Aufbringung des Maskenmaterials kann beispielsweise über ein Aufdrucken erfolgen.

In einer weiteren Ausgestaltung des Verfahrens werden die bei der Befestigung der mindestens einen Verbundplatte freibleibenden Abschnitte auf dem Hochdruckträger vor dem Aufbringen des Maskenmaterials mit mindestens einer Ausgleichsschicht abgedeckt. Damit wird durch die Ausgleichsschicht gewährleistet, dass das Maskenmaterial, beispielsweise als Schicht und/oder Folie, vollkommen plan über die gesamte Fläche des Hochdruckträgers aufgelegt werden kann und so keine Verzerrungen oder Verschiebungen durch durchhängen oder durchbiegen entstehen. Die so maskierten Hochdruckplatten werden belichtet, entwickelt und die Fotoschicht selektiv entfernt.

Gemäß einer dritten Lehre der vorliegenden Erfindung wird die oben genannte Aufgabe durch ein Verfahren zur Herstellung einer erfindungsgemäßen Verbundplatte gelöst, bei dem eine Trägerschicht, mindestens eine Fotoschicht, eine Sperrschicht und mindestens ein Maskenmaterial aufeinander aufgebracht werden, wobei die Fotoschicht auf der Trägerschicht angeordnet wird, wobei die Fotoschicht über elektromagnetische Strahlung in einem Wellenlängenbereich strukturierbar ist, wobei die Sperrschicht auf der von der Trägerschicht abgewandten Seite der Fotoschicht angeordnet wird, wobei die Sperrschicht im Wesentlichen transparent in dem Wellenlängenbereich ist, in welchem die Fotoschicht strukturierbar ist, wobei das Maskenmaterial Diazoverbindungen umfasst, wobei die Löslichkeit des Maskenmaterials durch selektive Belichtung im sichtbaren Bereich beeinflusst werden kann und bei dem das Aufbringen ein Laminieren umfasst.

Zur Herstellung der erfindungsgemäßen Verbundplatte für Hochdruckformen hat sich eine Kombination von mindestens einem Maskenmaterial umfassend Diazoverbindungen in Kombination mit einem Laminieren für die Aufbringung als besonders prozesssicher und wirtschaftlich herausgestellt.

Die Trägerschicht, Fotoschicht, Sperrschicht und das Maskenmaterial können hierbei in einem gemeinsamen Verfahrensschritt aufeinander gebracht werden. Ebenso können zunächst einzelne Schichten aufeinander gebracht werden, beispielsweise in Form eines Verbundmaterials, und anschließend zu der Verbundplatte kombiniert werden. Hierbei können einzelne oder alle Schritte des Aufbringens ein Laminieren umfassen. Weitere mögliche Methoden zum Aufbringen der Schichten sind beispielsweise ein Kalandrieren, Aufsprühen, Aufdrucken, Auflegen und/oder manuelles Anordnen, welche insbesondere mit dem Laminieren kombiniert werden können. Möglich ist auch die Bereitstellung und Aufbringung weiterer Schichten, beispielsweise mindestens einer Haftvermittlerschicht und/oder mindestens einer Schutzschicht.

In einer Ausgestaltung des Verfahrens gemäß der dritten Lehre wird die Sperrschicht zusammen mit dem Maskenmaterial auf der von der Trägerschicht abgewandten Seite der Fotoschicht aufgebracht. Hierdurch wird das Verfahren weiter verbessert, da die Aufbringung des Maskenmaterials erleichtert wird. Insbesondere entfällt die Notwendigkeit einer zusätzlichen Trägerfolie bzw. Releasefolie, welche die Aufbringung des Maskenmaterials ermöglichen soll und anschließend entfernt werden müsste. Vielmehr kann die Sperrschicht sowohl dafür dienen, als Trägerfolie ein Aufbringen des Maskenmaterials zu erleichtern, als auch - wie oben zur Verbundplatte beschrieben - insbesondere eine Diffusionssperrschicht in der Strukturierung der Verbundplatte zur Herstellung einer Hochdruckform bereitzustellen. Entsprechend entfallen in der Herstellung der Verbundplatte zusätzliche Verfahrensschritte, da keine zusätzliche Trägerschicht bereitgestellt und nach dem Aufbringen wieder entfernt werden muss. Hierdurch wird das Verfahren folglich auch kostengünstiger.

In einer weiteren Ausgestaltung wird das Maskenmaterial mit der Sperrschicht vor dem Aufbringen als Verbundmaterial bereitgestellt. Unter einem Verbundmaterial wird insbesondere verstanden, dass Maskenmaterial und Sperrschicht fest miteinander verbunden werden, beispielsweise durch Adhäsion und/oder durch einen Materialschluss. Beispielsweise wird das Maskenmaterial durch Laminieren auf der Sperrschicht aufgebracht. Insbesondere wird das Verbundmaterial durch Laminieren aufgebracht.

Gemäß einer vierten Lehre der vorliegenden Erfindung wird die oben genannte Aufgabe durch eine Verwendung eines Verbundmaterials gelöst, das Verbundmaterial aufweisend: eine Sperrschicht mit einer Schichtdicke von vorzugsweise höchstens 20 µm, wobei die Sperrschicht im Wesentlichen transparent in einem Wellenlängenbereich ist, welcher zur Strukturierung einer Fotoschicht geeignet ist und ein Maskenmaterial umfassend Diazoverbindungen; wobei das Verbundmaterial in einer Verbundplatte für eine Hochdruckplatte verwendet wird.

Wie bereits zum Verfahren gemäß der dritten Lehre beschrieben, kann durch das Verbundmaterial die Aufbringung des Maskenmaterials erleichtert werden, wobei die Sperrschicht gleichzeitig die Funktion einer Trägerfolie für das Maskenmaterial in der Herstellung der Verbundplatte und die Funktion einer Diffusionssperre für die Herstellung der Hochdruckform erfüllt.

In einer Ausgestaltung der Verwendung wird das Verbundmaterial in einer Verbundplatte für eine Flexodruckplatte verwendet bzw. das Verbundmaterial wird in der Herstellung einer Flexodruckplatte verwendet.

Insbesondere sollen durch die vorherige oder folgende Beschreibung von Verfahrensschritten gemäß bevorzugter Ausführungsformen der Verfahren auch entsprechende Ausgestaltungen einer Verbundplatte offenbart sein. Ebenfalls soll durch die Offenbarung von Ausgestaltungen der Verbundplatte deren Verwendung oder Erzeugung in Verfahrensschritten der Verfahren offenbart sein. Weiter sollen mit der Beschreibung der Verbundplatte und den Verfahren auch mögliche Ausgestaltungen der Verwendung offenbart sein.

Zu weiteren Ausgestaltungen der Verbundplatte, der Verfahren und der Verwendung wird zudem auf die nachfolgende Beschreibung von Ausführungsbeispielen anhand der Zeichnung verweisen. In der Zeichnung zeigen:
- Fig. 1: eine Verbundplatte,
- Fig. 2: ein Ausführungsbeispiel einer Verbundplatte,
- Fig. 3: ein weiteres Ausführungsbeispiel einer Verbundplatte,
- Fig. 4: das Ausführungsbeispiel aus Fig. 3 bei einer selektiven Belichtung der Fotoschicht,
- Fig. 5a, b: zwei Ausgestaltungen einer aus der Verbundplatte hergestellten Hochdruckform und
- Fig. 6: ein weiteres Ausführungsbeispiel einer Verbundplatte auf einem Hochdruckträger.

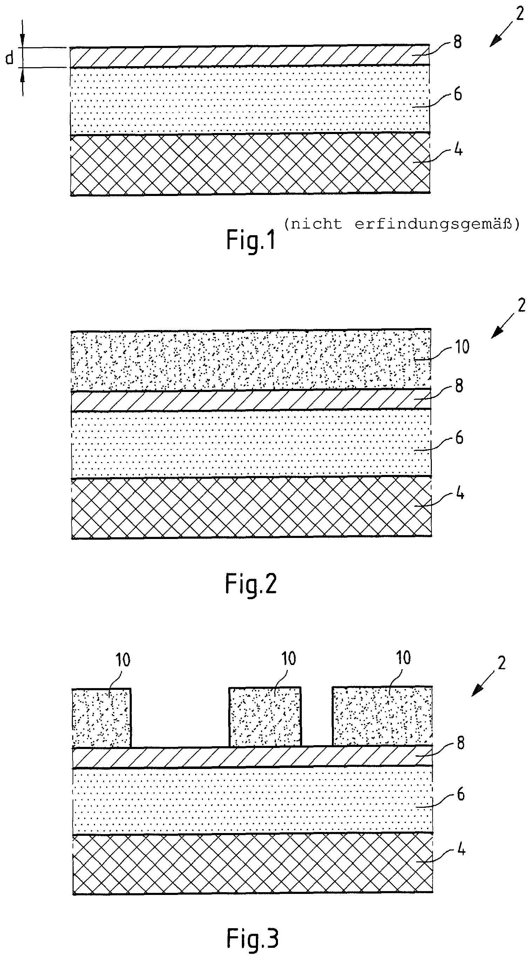

Fig. 1 (nicht erfindungsgemäß) zeigt eine Verbundplatte 2. Die Verbundplatte 2 weist eine Trägerschicht 4 und mindestens eine Fotoschicht 6 auf, wobei die Fotoschicht 6 auf der Trägerschicht 4 angeordnet ist. Die Fotoschicht 6 kann direkt auf der Trägerschicht 4 angeordnet sein oder optional ist mindestens eine Zwischenschicht vorgesehen, beispielsweise eine Haftvermittlerschicht (nicht gezeigt).

Die Fotoschicht 6 ist über elektromagnetische Strahlung in einem Wellenlängenbereich strukturierbar. Beispielsweise basiert die Fotoschicht 6 auf Fotopolymeren, wobei die Fotoschicht dafür eingerichtet ist, im ultravioletten und/oder violetten Wellenlängenbereich, d.h. beispielsweise innerhalb eines Bereichs von 100 nm bis 380 nm bzw. innerhalb eines Bereichs von 380 nm bis 425 nm, bestimmte Eigenschaften der Fotoschicht zu verändern, insbesondere die Löslichkeit und/oder die Aushärteeigenschaften.

Insbesondere über die Ausgestaltung der Trägerschicht 4 können die mechanischen Eigenschaften der Verbundplatte 2 eingestellt werden. Beispielsweise basiert die Trägerschicht 4 auf Polyethylenterephtalat und/oder weist eine Dicke von 0,05 mm bis 0,2 mm, insbesondere 0,1 mm bis 0,15 mm auf. Die Gesamtdicke der Verbundplatte 2 beträgt beispielsweise von 0,5 mm bis 3,0 mm. Insbesondere ist die Verbundplatte 2 für die Herstellung einer Flexodruckplatte eingerichtet.

Auf der Trägerschicht 4 abgewandten Seite der Fotoschicht 6 ist eine Sperrschicht 8 vorgesehen ist, wobei die Sperrschicht 8 eine Schichtdicke d von höchstens 100 µm, vorzugsweise höchstens 20 µm, insbesondere von höchstens 10 µm oder von höchstens 5 µm aufweist und wobei die Sperrschicht 8 im Wesentlichen transparent in dem Wellenlängenbereich ist, in welchem die Fotoschicht 4 strukturierbar ist. Beispielsweise ist die Sperrschicht 8 im ultravioletten und/oder violetten Wellenlängenbereich, d.h. beispielsweise innerhalb eines Bereichs von 100 nm bis 380 nm bzw. innerhalb eines Bereichs von 380 nm bis 425 nm, im Wesentlichen transparent, d.h. lässt in diesem Wellenlängenbereich einen Großteil der Strahlungsintensität durch. Insbesondere können mindestens 50 %, bevorzugt mindestens 75 %, weiter bevorzugt mindestens 95 % der einfallenden Intensität die Sperrschicht 8 durchdringen.

Die Sperrschicht 8 ist hierbei direkt auf der Fotoschicht 6 angeordnet und steht in somit in Kontakt zur Fotoschicht 6. Die Sperrschicht 8 stellt eine Diffusionssperre für die Fotoschicht 6 gegen die umgebende Atmosphäre bereit, wobei gleichzeitig eine Belichtung der Fotoschicht 6 durch die Sperrschicht 8 hindurch aufgrund der geringen Schichtdicke d und der transparenten Eigenschaften der Sperrschicht 8 ermöglicht wird. Die Sperrschicht 8 basiert beispielsweise auf mindestens einem Polymer. Die Sperrschicht 8 umfasst oder besteht beispielsweise aus Polyethylenterephtalat.

Es hat sich herausgestellt, dass die Qualität und Auflösung der aus der Verbundplatte 2 hergestellten Hochdruckplatte über die Sperrschicht 8 verbessert werden kann. Die Sperrschicht 8 verbleibt bei einer bei einer Belichtung der Fotoschicht 6 auf der Fotoschicht 6, wie auch im Zusammenhang mit den nachfolgenden Figuren erläutert wird. Insbesondere durch die geringe Schichtdicke von weniger als 20 µm, insbesondere weniger als 10 µm bzw. 5 µm werden Brechungseffekte an der Sperrschicht 8 eingedämmt, so dass durch die Sperrschicht 8 nur geringe oder keine Qualitätsverluste hervorgerufen werden. Gleichzeitig wird der Einfluss der umgebenden Atmosphäre durch die Sperrschicht 8 signifikant reduziert, was zu einer deutlichen Qualitätssteigerung der strukturierten Oberfläche der Fotoschicht 6 führt.

Im Folgenden werden Ausführungsbeispiele der Verbundplatte 2 anhand der Figuren 2 und 3 erläutert, wobei gleichzeitig ein Ausführungsbeispiel des erfindungsgemäßen Verfahrens beschrieben wird. In den nachfolgenden Figuren werden für entsprechende Elemente der Übersichtlichkeit halber die gleichen Bezugszeichen wie in Fig. 1 verwendet.

Fig. 2 zeigt ein Ausführungsbeispiel einer Verbundplatte2, wobei auf der Sperrschicht 8 mindestens ein Maskenmaterial 10 angeordnet ist. Das Maskenmaterial 10 ist hierbei als Schicht ausgebildet und deckt die Fotoschicht flächig ab. Das Maskenmaterial wird laminiert. Das Maskenmaterial 10 kann strukturiert werden, beispielsweise indem das Maskenmaterial 10 abschnittsweise entfernt wird und/oder abschnittsweise in den Eigenschaften verändert wird.

Das Maskenmaterial 10 ist dafür eingerichtet, unter der Einwirkung von elektromagnetischer Strahlung im sichtbaren Bereich seine Eigenschaften zu verändern. Vorteilhaft an der Verbundplatte 2 ist hierbei, dass die Fotoschicht 6 durch die Sperrschicht 8 bei der Belichtung von der umgebenden Atmosphäre abgeschirmt wird. Die Belichtung des Maskenmaterials 10 beeinträchtigt die Fotoschicht somit nur unwesentlich.

Das Maskenmaterial umfasst Diazoverbindungen, welche wie aus dem Stand der Technik bekannt selektiv belichtet und abgelöst werden können. Beispielsweise können entsprechende Verbindungen mit einer Wellenlänge von 405 nm belichtet und/oder mit einer Lösung enthaltend Ammoniak und/oder Wasser abgelöst werden. Bei der Verwendung einer Lösung zur Strukturierung des Maskenmaterials 10 bewirkt die Sperrschicht 8 vorteilhafterweise eine Eindämmung der Einwirkung der Lösung, beispielsweise einer Lösung umfassend Ammoniak, auf die Fotoschicht 6.

Fig. 3 zeigt ein weiteres Ausführungsbeispiel einer Verbundplatte 2, wobei das Maskenmaterial 10 eine Struktur zur selektiven Belichtung der Fotoschicht 6 aufweist. Die Struktur ist hierbei in Form von Ausnehmungen zwischen einzelnen Abschnitten des Maskenmaterials 10 dargestellt.

Die Struktur des Maskenmaterials 10 kann beispielsweise wie oben zur Fig. 2 beschrieben durch eine selektive Entfernung des Maskenmaterials 10 bewirkt werden. Das Maskenmaterial 10 basiert auf Diazoverbindungen und wird durch eine Belichtung im sichtbaren Bereich strukturiert.

Nicht erfindungsgemäß kann das Maskenmaterial 10 auch bereits über ein selektives Aufbringen des Maskenmaterials 10 strukturiert werden. Nicht erfindungsgemäß wird das Maskenmaterial 10 selektiv aufgedruckt und basiert insbesondere auf Tinte und/oder Wachs, bevorzugt auf einer Kombination einer UV-aushärtbaren Tinte und Wachs.

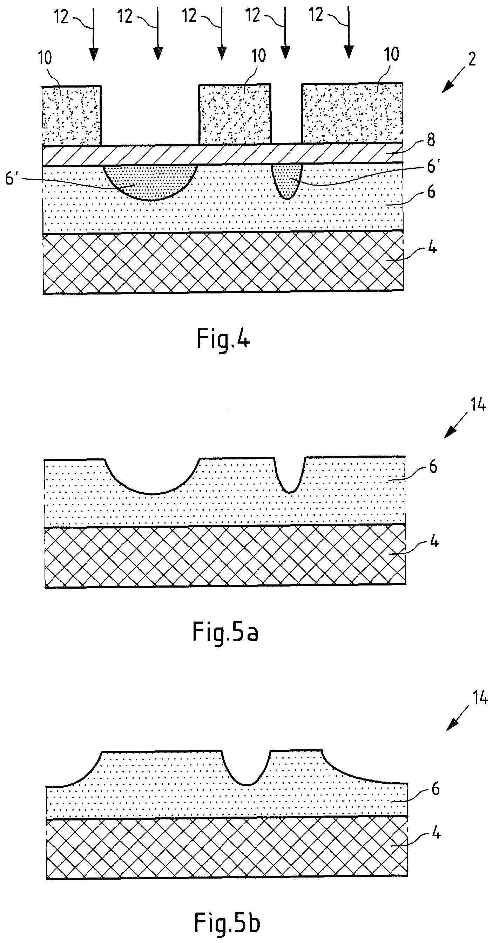

Fig. 4 zeigt nun das Ausführungsbeispiel der Verbundplatte 2 aus Fig. 3 bei einer selektiven Belichtung der Fotoschicht 6, wobei elektromagnetische Strahlung 12 zumindest in dem Wellenlängenbereich, in welchem die Fotoschicht 6 strukturierbar ist, auf die Verbundplatte 2 einwirkt. Die Sperrschicht 8 ist hierbei im Wesentlichen transparent für die Strahlung 12, so dass die Strahlung 12 aufgrund der Abdeckung durch das Maskenmaterial 10 selektiv auf Abschnitte 6' der Fotoschicht 6 einwirkt. Vorteilhaft an der Verbundplatte 2 ist hierbei, dass die Fotoschicht 6 durch die Sperrschicht 8 von der umgebenden Atmosphäre abgeschirmt wird und gleichzeitig nur geringe Brechungseffekte an der Sperrschicht 8 auftreten. Die Belichtung der Fotoschicht 6 kann somit mit hoher Auflösung und hoher Qualität erfolgen.

Die selektiv belichtete Fotoschicht 6 kann selektiv entfernt werden. Bei Fotopolymeren können beispielsweise übliche Verfahrensschritte zur Entwicklung und selektiven Ablösung der Fotoschicht 6 erfolgen. Insbesondere werden das Maskenmaterial 10 und/oder die Sperrschicht 8 vorher oder nachher entfernt.

Fig. 5a, b zeigt hierzu zwei Ausgestaltungen einer aus der Verbundplatte 2 hergestellten Hochdruckform, welche als Flexodruckformen 14 ausgeführt sind. Die in Fig. 5a dargestellte Flexodruckform 14 geht beispielsweise aus der in Fig. 4 gezeigten selektiv belichteten Verbundplatte 2 hervor, wobei die Fotoschicht 6 insbesondere positiv auf eine Belichtung reagiert. Beispielsweise wird die Löslichkeit der belichteten Abschnitte 6' erhöht, wodurch bei einer Ablösung in den entsprechenden Bereichen Ausnehmungen entstehen.

Die Fig. 5b zeigt analog hierzu eine Flexodruckform 14 mit einer negativen Reaktion der Fotoschicht 6. Beispielsweise wird die Löslichkeit der belichteten Abschnitte 6' verringert, wodurch bei einer Ablösung in den nicht belichteten Abschnitten Ausnehmungen entstehen.

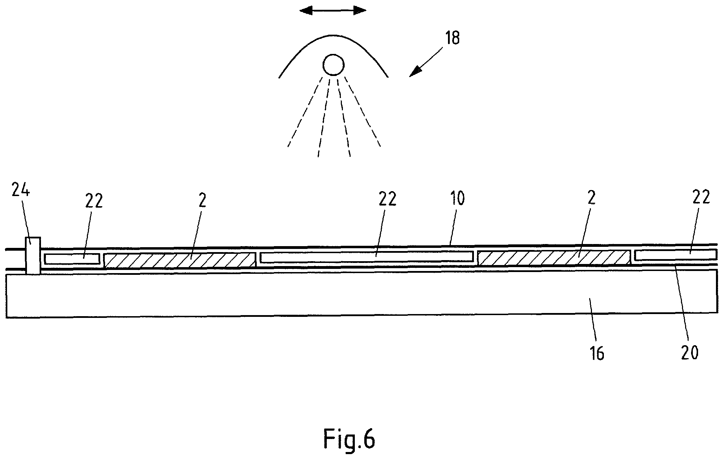

In Fig. 6 wird ein weiteres Ausführungsbeispiel von Verbundplatten 2 auf einem Hochdruckträger gezeigt. Oberhalb einer Auflage 16 ist eine Belichtungseinheit 18 vorgesehen, die im dargestellten Ausführungsbeispiel als linienförmige Lichtquelle skizziert ist, die zur vollständigen Belichtung relativ zur Auflage 16 verfahren werden kann.

Auf dem Flexodruckträger 20 sind Verbundplatten 2 befestigt. Eine Aufbringung des Maskenmaterials 10 kann beispielsweise durch ein Aufdrucken geschehen. In der Fig. 6 ist jedoch eine Ausgleichsschicht 22 in den freibleibenden Abschnitten auf dem Flexodruckträger 20 vorgesehen, so dass Maskenmaterial 10 auf die Verbundplatten 2 und die Ausgleichsschicht 22 aufgelegt werden kann. Durch die Anordnung der Ausgleichsschicht 22 ist gewährleistet, dass das Maskenmaterial 10 in den von der Ausgleichsschicht 22 abgedeckten Bereichen nicht durchhängt oder Wellen wirft. Eine besonders exakte Ausrichtung der Verbundplatten 2 kann insbesondere durch die Verwendung eines Registers 24 in besonders einfacher Art und Weise gewährleistet werden.

Wie aus dem Stand der Technik an sich bekannt, werden die zumindest teilweise unbelichteten Verbundplatten 2 vorzugsweise mit Hilfe eines Schneidplotters geschnitten. Zweckmäßigerweise erfolgt auch der Zuschnitt der Ausgleichsschicht 22 mit Hilfe eines solchen an sich bekannten Schneidplotters. Als Ausgleichsschicht 22 können verschiedene kostengünstige Materialien verwendet werden. Vorzugsweise haben diese eine im Wesentlichen übereinstimmende Dicke mit den Verbundplatten 2. In Frage kommen beispielsweise Materialien wie Pappe oder elastische Materialien wie etwa Gummi- oder Polymerplatten.

In einem Ausführungsbeispiel des Verfahren zur Herstellung einer Verbundplatte werden eine Trägerschicht, mindestens eine Fotoschicht, eine Sperrschicht und mindestens ein Maskenmaterial aufeinander aufgebracht.

Die Sperrschicht wird zusammen mit dem Maskenmaterial auf der von der Trägerschicht abgewandten Seite der Fotoschicht aufgebracht. Hierzu wird zunächst ein Verbundmaterial aus Maskenmaterial und Sperrschicht bereitgestellt, wobei das Maskenmaterial und die Sperrschicht durch Adhäsion und/oder durch einen Materialschluss miteinander verbunden sind. Beispielsweise wird das Maskenmaterial durch Laminieren auf der Sperrschicht aufgebracht.

Das Verbundmaterial aufweisend Maskenmaterial und Sperrschicht wird dazu verwendet, eine Verbundplatte zur Herstellung einer Hochdruckform bereitzustellen. Das Verbundmaterial wird hierzu auf eine Trägerschicht und eine Fotoschicht gebracht. Das Aufbringen des Verbundmaterials umfasst hierbei ein Laminieren. Insbesondere wird ein weiteres Verbundmaterial aufweisend Trägerschicht und Fotoschicht bereitgestellt, auf welches das Verbundmaterial aufweisend Maskenmaterial und Sperrschicht aufgebracht wird, insbesondere durch Laminieren.

Durch die Verwendung des Verbundmaterials aufweisend Maskenmaterial und Sperrschicht kann ein besonders wirtschaftliches Verfahren zur Herstellung der Verbundplatte durchgeführt werden. Die Notwendigkeit einer zusätzlichen Trägerfolie bzw. Releasefolie zur Aufbringung des Maskenmaterials entfällt mit der Sperrschicht, wobei die Sperrschicht gleichzeitig eine Diffusionssperrschicht für die anschließende Strukturierung der Verbundplatte zur Herstellung einer Hochdruckform bereitstellt.

## Patentansprüche

1. Verbundplatte zur Verwendung in der Herstellung einer Hochdruckplatte,
- mit einer Trägerschicht (4),
- mit mindestens einer Fotoschicht (6), welche über elektromagnetische Strahlung (12) in einem Wellenlängenbereich strukturierbar ist,
- wobei die Fotoschicht (6) auf der Trägerschicht (4) angeordnet ist,
- wobei eine Sperrschicht (8) vorgesehen ist, wobei die Sperrschicht (8) auf der von der Trägerschicht (4) abgewandten Seite der Fotoschicht (6) angeordnet ist,
- wobei die Sperrschicht (8) im Wesentlichen transparent in dem Wellenlängenbereich ist, in welchem die Fotoschicht (6) strukturierbar ist,
- wobei auf der Sperrschicht (8) mindestens ein Maskenmaterial (10) angeordnet ist und
- wobei das Maskenmaterial (10) durch Laminieren aufgebracht ist,
**dadurch gekennzeichnet, dass**
- das Maskenmaterial (10) Diazoverbindungen umfasst, wobei die Löslichkeit des Maskenmaterials (10) durch selektive Belichtung im sichtbaren Bereich beeinflusst werden kann.

2. Verbundplatte nach Anspruch 1,
**dadurch gekennzeichnet, dass**
die Sperrschicht (8) eine Schichtdicke (*d*) von höchstens 100 µm, vorzugsweise von höchstens 20 µm und weiter vorzugsweise von höchstens 10 µm aufweist.

3. Verbundplatte nach Anspruch 1 oder 2,
**dadurch gekennzeichnet, dass**
das Maskenmaterial (10) als Schicht ausgebildet ist.

4. Verbundplatte nach einem der Ansprüche 1 bis 3,
**dadurch gekennzeichnet, dass**
die Verbundplatte (2) zur Verwendung in der Herstellung einer Flexodruckplatte (14) eingerichtet ist.

5. Verfahren zur Herstellung einer Hochdruckplatte unter Verwendung mindestens einer Verbundplatte (2)
- mit einer Trägerschicht (4),
- mit mindestens einer Fotoschicht (6), welche über elektromagnetische Strahlung (12) in einem Wellenlängenbereich strukturierbar ist, wobei die Fotoschicht (6) auf der Trägerschicht (4) angeordnet ist,
- mit einer Sperrschicht (8), wobei die Sperrschicht (8) auf der von der Trägerschicht (4) abgewandten Seite der Fotoschicht (6) angeordnet ist,
- wobei die Sperrschicht (8) eine Schichtdicke (*d*) von vorzugsweise höchstens 20 µm aufweist,
- wobei die Sperrschicht (8) im Wesentlichen transparent in dem Wellenlängenbereich ist, in welchem die Fotoschicht (6) strukturierbar ist,
- bei dem mindestens ein Maskenmaterial (10) auf die Verbundplatte (2) durch Laminieren aufgebracht und das Maskenmaterial (10) selektiv strukturiert wird,
- wobei mindestens ein Maskenmaterial (10) umfassend Diazoverbindungen verwendet wird,
- wobei das Maskenmaterial (10) selektiv belichtet und selektiv entfernt wird,
- wobei die Löslichkeit des Maskenmaterials (10) durch selektive Belichtung im sichtbaren Bereich beeinflusst wird und
- wobei das Maskenmaterial (10) über eine Lösung strukturiert wird,
- bei dem die Fotoschicht (6) zumindest in dem Wellenlängenbereich, in welchem die Fotoschicht (6) strukturierbar ist, selektiv belichtet wird und
- bei dem die selektiv belichtete Fotoschicht (6) selektiv entfernt wird.

6. Verfahren nach Anspruch 5,
**dadurch gekennzeichnet, dass**
mindestens ein Maskenmaterial (10) als Schicht aufgebracht wird.

7. Verfahren nach Anspruch 5 oder 6,
**dadurch gekennzeichnet, dass**
die mindestens eine Verbundplatte (2) abschnittsweise auf einem Hochdruckträger (20) befestigt wird.

8. Verfahren nach Anspruch 7,
**dadurch gekennzeichnet, dass**
die bei der Befestigung der mindestens einen Verbundplatte (2) freibleibenden Abschnitte auf dem Hochdruckträger (20) vor dem Aufbringen des Maskenmaterials (10) mit mindestens einer Ausgleichsschicht (22) abgedeckt werden.

9. Verfahren zur Herstellung einer Verbundplatte (2) nach einem der Ansprüche 1 bis 4,
- bei dem eine Trägerschicht (4), mindestens eine Fotoschicht (6), eine Sperrschicht (8) und mindestens ein Maskenmaterial (10) aufeinander aufgebracht werden,
- wobei die Fotoschicht (6) auf der Trägerschicht (4) angeordnet wird,
- wobei die Fotoschicht (6) über elektromagnetische Strahlung (12) in einem Wellenlängenbereich strukturierbar ist,
- wobei die Sperrschicht (8) auf der von der Trägerschicht (4) abgewandten Seite der Fotoschicht (6) angeordnet wird und die Sperrschicht (8) im Wesentlichen transparent in dem Wellenlängenbereich ist, in welchem die Fotoschicht (6) strukturierbar ist,
- wobei das Maskenmaterial (10) Diazoverbindungen umfasst, wobei die Löslichkeit des Maskenmaterials (10) durch selektive Belichtung im sichtbaren Bereich beeinflusst werden kann und
- bei dem das Aufbringen ein Laminieren umfasst.

10. Verfahren nach Anspruch 9,
**dadurch gekennzeichnet, dass**
die Sperrschicht (8) zusammen mit dem Maskenmaterial (10) auf der von der Trägerschicht (4) abgewandten Seite der Fotoschicht (6) aufgebracht wird.

11. Verfahren nach Anspruch 9 oder 10,
**dadurch gekennzeichnet, dass**
das Maskenmaterial (10) mit der Sperrschicht (8) als Verbundmaterial bereitgestellt wird und das Verbundmaterial insbesondere durch Laminieren aufgebracht wird.

12. Verwendung eines Verbundmaterials aufweisend:
- eine Sperrschicht (8) mit einer Schichtdicke (*d*) von vorzugsweise höchstens 20 µm, wobei die Sperrschicht (8) im Wesentlichen transparent in einem Wellenlängenbereich ist, welcher zur Strukturierung einer Fotoschicht (6) geeignet ist und
- ein Maskenmaterial (10) umfassend Diazoverbindungen, wobei die Löslichkeit des Maskenmaterials (10) durch selektive Belichtung im sichtbaren Bereich beeinflusst werden kann;
- wobei das Verbundmaterial in einer Verbundplatte (2) für eine Hochdruckplatte verwendet wird.

13. Verwendung nach Anspruch 12,
wobei das Verbundmaterial in einer Verbundplatte (2) für eine Flexodruckplatte verwendet wird.

## Claims

1. Composite panel for use in the manufacture of a letterpress plate,
- with a carrier layer (4),
- with at least one photo layer (6), which can be structured via electromagnetic radiation (12)in a wavelength range,
- in which the photo layer (6) is arranged on the carrier layer (4),
- in which a barrier layer (8) is provided, in which the barrier layer (8) is arranged on the side of the photo layer (6) facing away from the carrier layer (4),
- in which the barrier layer (8) is substantially transparent in the wavelength range in which the photo layer (6) is structurable,
- in which at least one mask material (10) is arranged on the barrier layer (8), and
- in which the mask material (10) is applied by lamination,
**characterized in that**
- the mask material (10) comprises diazo compounds, in which the solubility of the mask material (10) can be influenced by selective exposure in the visible range.

2. Composite panel according to claim 1,
**characterized in that**
the barrier layer (8) has a layer thickness (*d*) of at most 100 µm, preferably of at most 20 µm and more preferably of at most 10 µm.

3. Composite panel according to claim 1 or 2,
**characterized in that**
the mask material (10) is formed as a layer.

4. Composite panel according to any one of claims 1 to 3,
**characterized in that**
the composite panel (2) is adapted for use in the manufacture of a flexographic printing plate (14).

5. Method for manufacturing a letterpress plate using at least one composite panel (2)
- with a carrier layer (4),
- with at least one photo layer (6) which can be structured via electromagnetic radiation (12) in a wavelength range, in which the photo layer (6) is arranged on the carrier layer (4),
- with a barrier layer (8), in which the barrier layer (8) is arranged on the side of the photo layer (6) opposite to the carrier layer (4),
- in which the barrier layer (8) has a layer thickness (*d*) of preferably at most 20 µm,
- in which the barrier layer (8) is substantially transparent in the wavelength range in which the photo layer (6) is structurable,
- in which at least one mask material (10) is applied to the composite panel (2) by lamination and the mask material (10) is selectively structured,
- in which at least one mask material (10) comprising diazo compounds is used,
- in which the mask material (10) is selectively exposed and selectively removed,
- in which the solubility of the mask material (10) is influenced by selective exposure in the visible range, and
- in which the mask material (10) is structured using a solution,
- in which the photo layer (6) is selectively exposed at least in the wavelength range in which the photo layer (6) is structurable and
- in which the selectively exposed photo layer (6) is selectively removed.

6. Method according to claim 5,
**characterized in that**
at least one mask material (10) is applied as a layer.

7. Method according to claim 5 or 6,
**characterized in that**
the at least one composite panel (2) is fastened in sections on a letterpress carrier (20).

8. Method according to claim 7,
**characterized in that**
the portions on the letterpress carrier (20) which remain free during the fastening of the at least one composite panel (2) are covered with at least one compensating layer (22) prior to the application of the mask material (10).

9. Method for the manufacture of a composite panel (2) in accordance with any one of claims 1 to 4,
- in which a carrier layer (4), at least one photo layer (6), a barrier layer (8) and at least one mask material (10) are applied to one another,
- in which the photo layer (6) is arranged on the carrier layer (4),
- in which the photo layer (6) can be structured via electromagnetic radiation (12) in a wavelength range,
- in which the barrier layer (8) is arranged on the side of the photo layer (6) opposite to the carrier layer (4) and the barrier layer (8) is substantially transparent in the wavelength range in which the photo layer (6) is structurable,
- in which the mask material (10) comprises diazo compounds, in which the solubility of the mask material (10) can be influenced by selective exposure in the visible range and
- in which the application involves laminating.

10. Method according to claim 9,
**characterized in that**
the barrier layer (8) is applied together with the mask material (10) to the side of the photo layer (6) opposite to the carrier layer (4).

11. Method according to claim 9 or 10,
**characterized in that**
the mask material (10) is provided with the barrier layer (8) as a composite material and the composite material is applied in particular by lamination.

12. Use of a composite material comprising:
- a barrier layer (8) with a layer thickness (*d*) of preferably at most 20 µm, in which the barrier layer (8) is substantially transparent in a wavelength range which is suitable for structuring a photo layer (6) and
- a mask material (10) comprising diazo compounds, in which the solubility of the mask material (10) can be influenced by selective exposure in the visible range;
- in which the composite material is used in a composite panel (2) for a letterpress plate.

13. Use according to claim 12,
in which the composite material is used in a composite panel (2) for a flexographic printing plate.

## Revendications

1. Panneau composite utilisée pour la fabrication d'une plaque typographique,
- avec une couche de support (4),
- avec au moins une couche photographique (6), qui peut être structurée par un rayonnement électromagnétique (12) dans une gamme de longueurs d'onde,
- dans lequel la couche photo (6) est disposée sur la couche de support (4),
- dans lequel une couche barrière (8) est prévue, dans lequel la couche barrière (8) étant disposée sur le côté de la couche photo (6) opposé à la couche de support (4),
- dans lequel la couche barrière (8) est essentiellement transparente dans la gamme de longueurs d'onde dans laquelle la couche photo (6) peut être structurable,
- dans lequel au moins un matériau de masque (10) est disposé sur la couche barrière (8) et
- dans lequel le matériau du masque (10) est appliqué par laminage,
**caractérisé en ce que**
- le matériau de masque (10) comprend des composés diazo, dans lequel la solubilité du matériau de masque (10) peut être influencée par une exposition sélective dans le domaine visible.

2. Panneau composite selon la revendication 1,
**caractérisé en ce que**
la couche barrière (8) a une épaisseur de couche (*d*) de 100 µm au maximum, de préférence de 20 µm au maximum et plus préférablement de 10 µm au maximum.

3. Panneau composite selon l'une des revendications 1 ou 2,
**caractérisé en ce que**
le matériau du masque (10) est formé en couche.

4. Panneau composite selon l'une des revendications 1 à 3,
**caractérisé en ce que**
le panneau composite (2) est adaptée pour être utilisée dans la fabrication d'une plaque d'une plaque flexographique (14).

5. Procédé pour la production d'une plaque typographique utilisant au moins une plaque composite (2)
- avec une couche de support (4),
- avec au moins une couche photo (6) qui peut être structurée par un rayonnement électromagnétique (12) dans une gamme de longueurs d'onde, dans lequel la couche photo (6) étant disposée sur la couche de support (4),
- avec une couche barrière (8), dans lequel la couche barrière (8) étant disposée sur le côté de la couche photo (6) opposé à la couche support (4),
- dans lequel la couche barrière (8) a une épaisseur de couche (*d*) de préférence de 20 µm au maximum,
- dans laquelle la couche barrière (8) est essentiellement transparente dans la gamme de longueurs d'onde dans laquelle la couche photo (6) peut être structurable,
- dans lequel au moins un matériau de masque (10) est appliqué sur le panneau composite (2) est appliqué par laminage et le matériau du masque (10) est structuré de manière sélective,
- dans lequel on utilise au moins un matériau de masque (10) comprenant des composés diazo,
- dans lequel le matériau du masque (10) est exposé et enlevé de manière sélective,
- dans lequel la solubilité du matériau du masque (10) est influencée par une exposition sélective dans le domaine visible et
- dans lequel le matériau du masque (10) est structuré au moyen d'une solution,
- dans lequel la couche photographique (6) est exposée de manière sélective au moins dans la gamme de longueurs d'onde dans laquelle la couche photographique (6) peut être structurée, et
- dans lequel la couche de photos (6) exposée de manière sélective est enlevé de manière sélective.

6. Procédé selon la revendication 5,
**caractérisé en ce que**
au moins un matériau de masque (10) est appliqué en couche

7. Procédé selon l'une des revendications 5 ou 6,
**caractérisé en ce que**
au moins un panneau composite (2) est fixé par sections sur un support haute pression (20).

8. Procédé selon la revendication 7,
**caractérisé en ce que**
les parties qui restent libres lors de la fixation du au moins un panneau composite (2) sur le support haute pression (20) sont recouvertes d'au moins une couche de compensation (22) avant que le matériau du masque (10) ne soit appliqué.

9. Procédé de production d'un panneau composite (2) selon l'une des revendications 1 à 4,
- dans lequel une couche de support (4), au moins une couche photo (6), une couche barrière (8) et au moins un matériau de masque (10) sont appliqués les uns sur les autres,
- dans lequel la couche photo (6) est disposée sur la couche de support (4),
- dans lequel la couche photo (6) est structurable par le rayonnement électromagnétique (12) dans une gamme de longueurs,
- dans lequel la couche barrière (8) est disposée sur le côté de la couche photo (6) opposé à la couche de support (4) et la couche barrière (8) est essentiellement transparente dans la gamme de longueurs d'onde dans laquelle la couche photo (6) peut être structurée,
- dans lequel le matériau de masque (10) comprend des composés diazo, dans lequel la solubilité du matériau de masque (10) peut être influencée par une exposition sélective dans le domaine visible et
- lorsque la demande implique une laminage.

10. Procédé selon la revendication 9,
**caractérisé en ce que**
la couche barrière (8) est appliquée avec le matériau du masque (10) sur le côté de la couche photo (6) éloigné de la couche de support (4).

11. Procédé selon l'une des revendications 9 ou 10,
**caractérisé en ce que**
le matériau du masque (10) avec la couche barrière (8) est fourni sous forme de matériau composite et le matériau composite est appliqué notamment par laminage.

12. Utilisation d'un matériau composite comprenant :
- une couche barrière (8) avec une épaisseur de couche (*d*) de préférence de 20 µm au maximum, dans lequel la couche barrière (8) étant essentiellement transparente dans une gamme de longueurs d'onde appropriée pour la structuration d'une couche photographique (6) et
- un matériau de masque (10) comprenant des composés diazo, dans lequel la solubilité du matériau de masque (10) peut être influencée par une exposition sélective dans le domaine visible;
- dans lequel le matériau composite est utilisé dans un panneau composite (2) pour une plaque typographique

13. Utilisation selon la revendication 12,
dans lequel le matériau composite est utilisé dans un panneau composite (2) pour une plaque d'une plaque flexographique.
